# EUROPEAN PATENT APPLICATION

(11) **EP 0 989 673 A2**
(43) Date of publication of application: **29.03.2000**
(21) Application number: 99117917.7
(22) Date of filing: 14.09.1999
(51) Int. Cl.: H03K 19/00, G11C 7/10

(54) **Low power digital input circuit**

(30) Priority: 16.09.1998 US 154017
(71) Applicant: MICROCHIP TECHNOLOGY INC., Chandler, AZ 85224-6199 (US)
(72) Inventor: Smit, Willem, Chandler, Arizona 85248 (US); van Rooyen, Emile, Phoenix, Arizona 85044 (US); van Nierkerk, Johannes Albertus, Chandler, Arizona 85226 (US)
(74) Representative: Frohwitter, Bernhard, Dipl.-Ing.

(57) **Abstract**

An input circuit for minimizing power consumption in connected circuits is implemented. The input buffer has a saturating amplifier with a gain greater than unity, which provides for rapid transition of slowly rising or slowly falling inputs, thereby minimizing the time interval of the cross conduction range. The input buffer also has a current source which provides a constant current that limits the current when the input is within the cross conducting range. This invention is especially useful for inputs which are slowly falling or rising, where connected output circuits may be in the cross-conducting range for extended periods.

## Description

This invention relates generally to digital circuits, and more specifically, to a digital input circuit using a gain substantially greater than unity to reduce the time that the output voltage is within the cross-conducting range for connected circuits.

This invention relates also to digital circuits for responding to slowly rising or falling input signals, and more specifically a digital input circuit using a gain substantially greater than unity to reduce power consumption when a slowly rising or falling input signal is applied.

The reduction of power consumption in MOS circuits is a concern that has been addressed by many techniques in the known art. Specifically, the subject of cross-conduction (commonly referred to as "crowbarring," the result of a low resistance path between the supply voltage and ground potential) and the need to reduce the range for which an input signal will cause cross-conduction in MOS circuits has been addressed frequently. Cross-conduction occurs in a CMOS (Complementary Metal Oxide Semiconductor) stage when the two transistors comprising the stage are both conducting. This typically happens at the midpoint of the power supply rails, but can vary due to device parameters, i.e. doping, environment and transistor size.

When a slowly varying input signal is applied to a CMOS stage, the cross-conducting range can be entered for an extended period of time. This can make device current uneven and increase the power consumption to unsuitable levels during the cross-conduction interval.

The present invention reduces the effect of cross-conduction by providing a voltage gain substantially greater than unity resulting in inherently low and constant power consumption. The range of input voltages which cause the connected device to cross-conduct is reduced by the voltage gain of the input buffer.

The present invention also reduces the capacitance required for resistor capacitor time constant generators. Since the threshold voltage of the input buffer is increased, the time required to charge a capacitor through a current source is increased by the same factor. Thus resulting in a reduction of the capacitor size and cost for a given time constant. When the capacitance is charged through a resistor, the reduction in capacitance can be even greater, since the rise in voltage with respect to time slows exponentially as the threshold is approached.

It is an object of the present invention to provide an input circuit to reduce power consumption in connected digital circuits.

It is another object of the present invention to provide an input circuit for reducing power consumption in connected digital circuits when the input circuit is being driven by a slowly changing input signal.

It is another object of the present invention to provide a input buffer for reducing the power consumption of digital circuits by providing input amplification.

It is another object of the present invention to provide a input buffer for reducing the transient power consumption of digital circuits by providing a constant current source.

It is another object of the present invention to provide an input circuit for reducing power consumption in connected digital circuits which reduces the capacitance required for a time constant generator.

In accordance with one embodiment of the present invention, an input buffer is implemented which reduces power consumption of circuits connected to its output, particularly when the input signal is slowly varying. This type of input buffer is useful for reset inputs to microcontrollers and other inputs which might be connected to a circuit with a long time constant or slow rise and fall times.

This circuit has a further advantage for input sources which are provided by a resistor-capacitor time constant generator. Since the voltage gain of the input buffer raises the threshold voltage to be near the power supply rail, the effective threshold voltage of the input buffer will reduce the capacitance required for time constant circuits being charged from the opposite rail until the threshold is crossed. This reduced capacitance requirement can lower cost and space requirements for circuits with long time constants.

The input buffer comprises a current source and a saturating amplifier. The voltage gain of the saturating amplifier is set to a value substantially greater than unity which results in minimizing the time interval of the cross conduction range. The current source provides a constant current which caps the current loss when in the cross conduction range.

The foregoing and other objects, features, and advantages of the invention will be apparent from the following, more particular, description of the preferred embodiment of the invention, as illustrated in the accompanying drawings.
Figure 1 is a simplified block diagram of the input buffer.
Figure 2 is a simplified electrical diagram of the preferred embodiment.
Figure 3 is a drawing of the transfer characteristic of the input buffer.

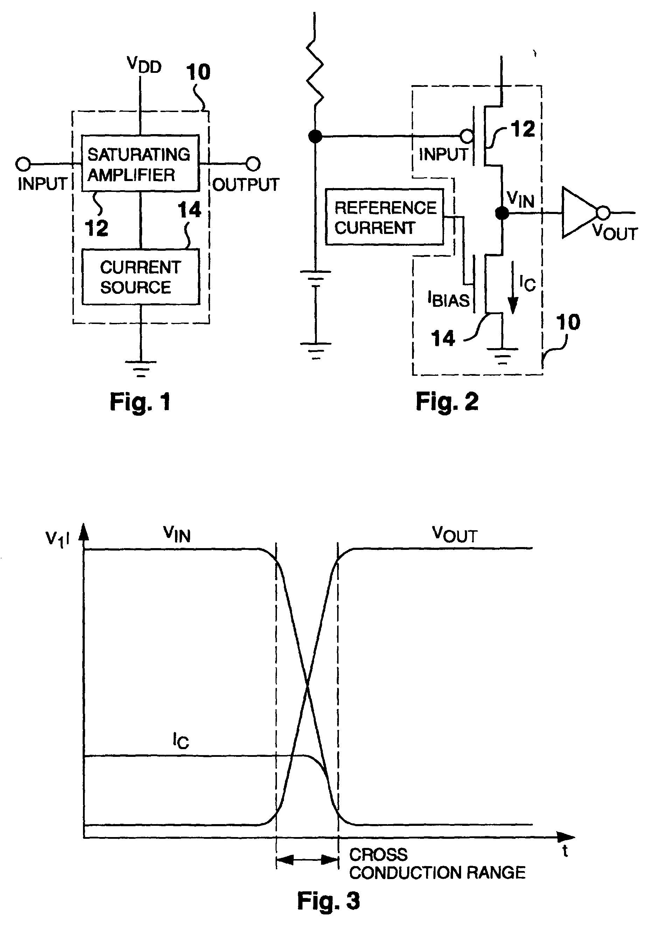

Referring to Figure 1, a block diagram of the preferred embodiment of the Input Buffer 10, is shown. A Saturating Amplifier 12 is driven by a Current Source 14 to provide an output for driving a CMOS (Complementary Metal Oxide Semiconductor) or other logic device.

Referring now also to Figure 2, where like numerals represent like elements, a electrical diagram of the preferred embodiment of the Input Buffer 10 is shown. MOS transistor 12 implements the Saturating Amplifier 12. The device characteristic of Transistor 12 is chosen so that the gain of the Input Buffer 10 is substantially greater than unity. This makes the threshold voltage of the Input Buffer 10 greater than that of a device connected to the output. By choosing a high gain for Input Buffer 10, the range of voltages for which a device connected to the output will cross conduct is reduced by a factor of that voltage gain.

MOS Transistor 14 implements Current Source 14. I_{BIAS} is connected to the control electrode of Transistor 14. Transistor 14 provides a constant current I_{C}. The device characteristic of Transistor 14 is chosen to select the proper, constant I_{C} when the Input Buffer 10 is in the cross conduction range. I_{C} may have a range from 0.1 microamps (ua) to 10 ua. In the preferred embodiment I_{C} is about 1 ua.

Referring now to Figure 3, wherein like symbols represent like elements, voltages and currents, the transfer characteristic of the Input Buffer 10 (Figure 1) is shown. The diagram illustrates V_{IN}, V_{OUT} and I_{C}. The vertical axis is magnitude (whether current or voltage) and the horizontal axis is time.

The present invention notes two important characteristics. First, the steepness of the transition in V_{IN} provides for a minimum time interval for lingering in the cross conduction range. Thus, the saturating amplifier 12 results in increasing the rate of the transfer function of V_{IN} in the transition or cross conduction range.

Second, I_{C} provides for a constant and maximum current when in the cross conduction range. Thus, the present invention not only reduces the time interval of the cross conduction range, but also caps the crowbarred current at I_{C}.

While the invention has been particularly shown and described with reference to the preferred embodiments thereof, it will be understood by those skilled in the art that the foregoing and other changes in form, and details may be made therein without departing from the spirit and scope of the invention.

## Claims

1. An input buffer for minimizing power consumption in a connected device comprising, in combination:
a current source for limiting the current in said input buffer in the cross conduction range; and
a saturating amplifier coupled to said current source and having an input gain substantially greater than unity for increasing the rate of the transfer function.

2. The input buffer for minimizing power consumption in a connected device in accordance with claim 1 wherein said input buffer is comprised of CMOS technology.

3. The input buffer for minimizing power consumption in a connected device in accordance with claim 1 wherein said saturating amplifier comprises a MOS transistor.

4. The input buffer for minimizing power consumption in a connected device in accordance with claim 1 wherein said saturating amplifier comprises a bipolar transistor.

5. The input buffer for minimizing power consumption in a connected device in accordance with claim 1 wherein said saturating amplifier comprises a comparator.

6. The input buffer for minimizing power consumption in a connected device in accordance with claim 1 wherein said input gain is greater than or equal to 2.

7. The input buffer for minimizing power consumption in a connected device in accordance with claim 1 wherein said input gain is greater than or equal to 5.

8. The input buffer for minimizing power consumption in a connected device in accordance with claim 1 wherein said input gain is greater than or equal to 10.

9. The input buffer for minimizing power consumption in a connected device in accordance with claim 1 wherein the current source provides a constant current.

10. The input buffer for minimizing power consumption in a connected device in accordance with claim 1 wherein the current source provides a constant current of between 0.1 and 10 microamps.

11. The input buffer for minimizing power consumption in a connected device in accordance with claim 1 wherein the current source provides a constant current of about 1 microamp.
